# EUROPEAN PATENT SPECIFICATION

(11) **EP 1 709 674 B1**
(45) Date of publication and mention of the grant of the patent: **05.03.2008**
(21) Application number: 05743263.5
(22) Date of filing: 23.05.2005
(51) Int. Cl.: H01L 21/56, H01L 23/31

(54) **METHOD FOR FABRICATING ELECTRONIC COMPONENT MODULE USING A PLASMA PROCESSING METHOD**
VERFAHREN ZUR HERSTELLUNG EINES ELEKTRONISCHEN KOMPONENTMODULS, WOBEI EIN PLASMAVERFAHREN VERWENDET WIRD
MÉTHODE DE FABRICATION DE MODULE DE COMPOSANT ÉLECTRONIQUE UTILISANT UNE MÉTHODE DE TRAITEMENT DE PLASMA

(30) Priority: 26.05.2004 JP 2004155836
(43) Date of publication of application: 11.10.2006
(73) Proprietor: Matsushita Electric Industrial Co., Ltd., Kadoma-shi, Osaka 571-8501 (JP)
(72) Inventor: NONOMURA, Masaru, Matsushita El.Ind.Co.Ltd., Chuo-ku, Osaka-shi, Osaka 540-6319 (JP); MIZUKAMI, Tatsuhiro, Matsushita El. Ind. Co., Chuo-ku, Osaka-shi, Osaka 540-6319 (JP)
(74) Representative: Pautex Schneider, Nicole Véronique
(86) International application number: PCT/JP2005/009817
(87) International publication number: WO 2005/117094

(56) References cited:
- US-B1- 6 306 683
- US-B1- 6 723 627
- PATENT ABSTRACTS OF JAPAN vol. 2000, no. 25, 12 April 2001 (2001-04-12) & JP 2001 237256 A (MATSUSHITA ELECTRIC IND CO LTD), 31 August 2001 (2001-08-31) cited in the application

## Description

### TECHNICAL FIELD

The present invention relates to a plasma processing method for surface modification for the purpose of improving a filling property of resin. The present invention also relates to a method for fabricating an electronic component module by using the plasma processing method. In the fabricating method, resin is filled in between an electronic component and a circuit board. The electronic component is coupled with the circuit board via protruding electrodes interposed therebetween.

### BACKGROUND ART

In mounting of an electronic component such as a flip chip that is coupled with a circuit board via bumps, which are protruding electrodes formed on the lower surface of the electronic component, a structure for reinforcement by filling resin in a gap between the electronic component and the circuit board is widely used. Furthermore, when this gap is narrow, a filling property of resin is deteriorated. Therefore, prior to filling of resin, various techniques for surface modification by performing plasma processing to surfaces of the circuit board and the electronic component in the gap are well-known.

According to, for example, Japanese Patent Unexamined Publication No. JP-A-2000091373, oxygen gas is used as a gas for plasma discharge. Then active substances such as oxygen radicals generated by plasma discharge are allowed to enter a gap between an electronic component and a circuit board and brought into contact with the surfaces of the circuit board and the electronic component. Thus, by physical and chemical actions of oxygen radicals, the inner surface of the gap is modified. Consequently, the wettability of the inner surface of the gap with respect to resin is improved and the filling property of resin is improved.

In Japanese Patent Unexamined Publication No. JP-A-2001-237256, in the above mentioned surface modification by using oxygen radicals, pressure conditions of a gas for plasma discharge at the time of plasma processing is optimized. Thus, the processing efficiency is improved. In addition, in Japanese Patent Unexamined Publication No. JP-A-2001-110825, which corresponds to document US-B-6 723 627, a mixed gas containing oxygen and argon is used as a gas for plasma discharge. Thus, a resin surface of inner surface of a gap is roughened, improving the wettability.

In the plasma processing for surface modification, oxygen radicals generated under reduced pressure conditions diffuse and enter the above-mentioned inner surface of the gap from an outer periphery of the electronic component. Oxygen radicals further diffuse toward the central portion in the gap, and are brought into contact with the surface to be processed. In such conventional technologies, however, the following problems arise as the gap between the electronic component and the circuit board becomes narrower and the number of bumps is increased in accordance with the demand for miniaturization of electronic equipment.

That is to say, under conditions where a gap is narrow and the number of bumps is large, it is difficult to allow a sufficient amount of oxygen radical to reach a deep portion of the gap for a short time. Accordingly, in order to achieve a sufficient modification effect, it is necessary to considerably extend the processing time. Therefore, with the surface modification by a conventional plasma processing, in the case where the inside of a micro gap is subjected to processing, it is difficult to obtain a sufficient surface modification effect efficiently.

### SUMMARY OF THE INVENTION

According to a plasma processing method of the present invention as defined in the appended claims, a surface of a micro gap provided between a first subject, which is a circuit board, to be processed and a second subject, which is an electronic component, to be processed is processed. In this plasma processing method, the first and second subjects to be processed are disposed within a process chamber. Then, the pressure inside the process chamber is reduced and a mixed gas containing oxygen and helium is introduced. In addition, in the pressure-reduced process chamber, plasma is generated so as to process the surfaces of the first and second subjects to be processed which face each other in the micro gap. With this method, a large number of gas particles are allowed to enter the micro gap between the subjects to be processed, and the surface modification can be carried out efficiently. By applying this method to a workpiece having a circuit board and an electronic component in which an electrode on the circuit board is coupled with another electrode on an electronic component, a sealing resin is easily filled in between the circuit board and the component.

### BRIEF DESCRIPTION OF THE DRAWINGS

Fig. 1 is a sectional view showing a plasma processing apparatus in accordance with an exemplary embodiment of the present invention.
Fig. 2 is a view to illustrate a state of plasma processing space in a plasma processing method in accordance with the exemplary embodiment of the present invention.
Fig. 3 is a view to illustrate a state in which oxygen radicals diffuse in the plasma processing method in accordance with the exemplary embodiment of the present invention.
Figs. 4A and 4B are views to illustrate dummy workpieces and experimental method in the plasma processing method in accordance with the exemplary embodiment of the present invention.
Fig. 4C is an enlarged view of Fig. 4B.
Figs. 5A and 5B are graphs showing the surface modification effect by the plasma processing method in accordance with the exemplary embodiment of the present invention.
Figs. 6A and 6B are views to illustrate dummy workpieces and experimental method in the plasma processing method in accordance with the exemplary embodiment of the present invention.
Fig. 6C is a view to illustrate a method for evaluating the surface modification effect by plasma processing methods.
Fig. 7A is a graph showing the surface modification effect by a conventional plasma processing method.
Fig. 7B is a graph showing the surface modification effect by the plasma processing method in accordance with the exemplary embodiment of the present invention.
Figs. 8A to 8D are views to illustrate steps of fabricating an electronic component module in accordance with the exemplary embodiment of the present invention.

### DETAILED DESCRIPTION OF PREFERRED EMBODIMENT

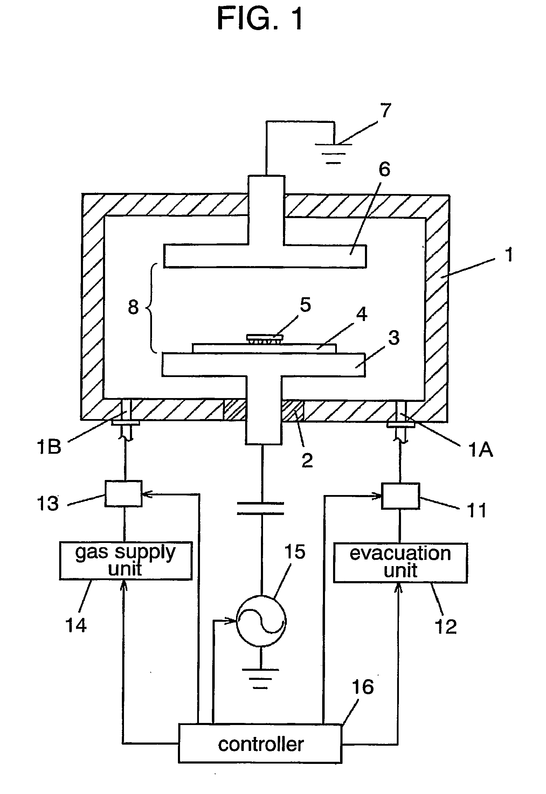

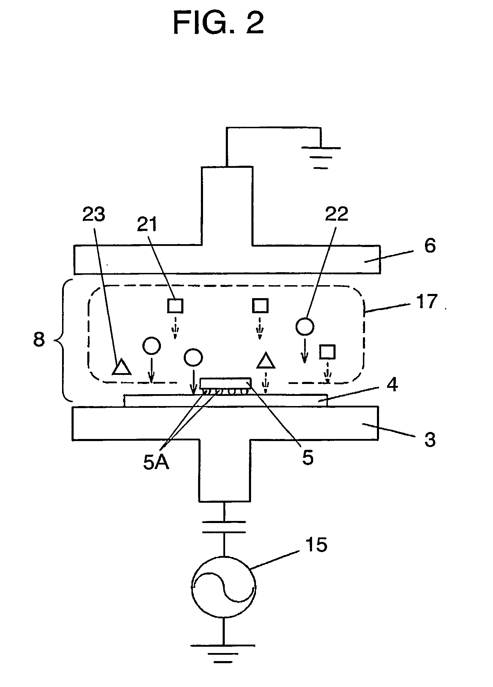

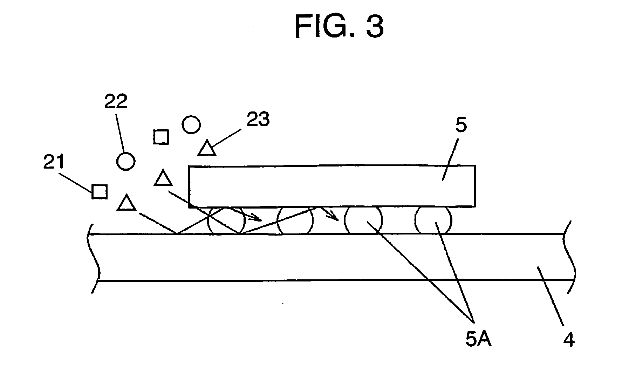

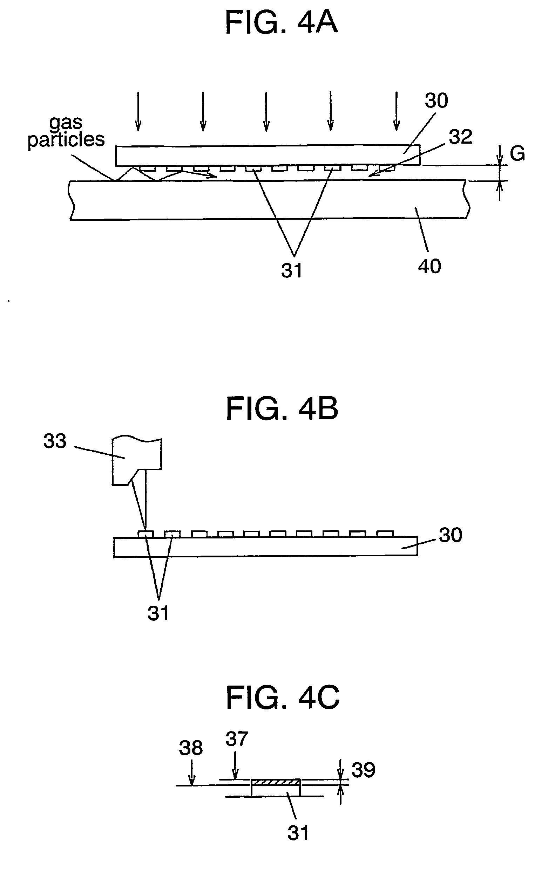

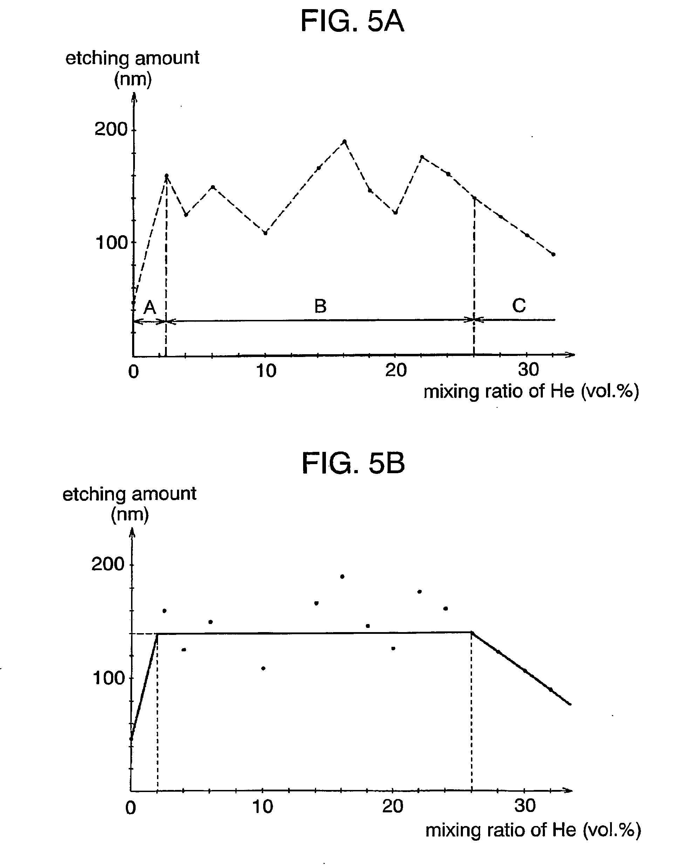

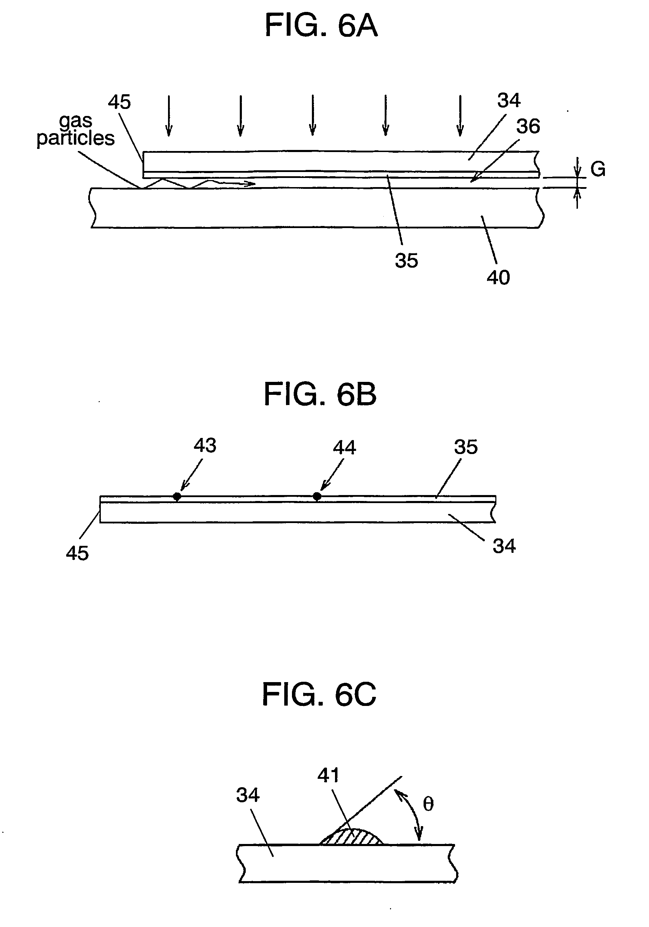

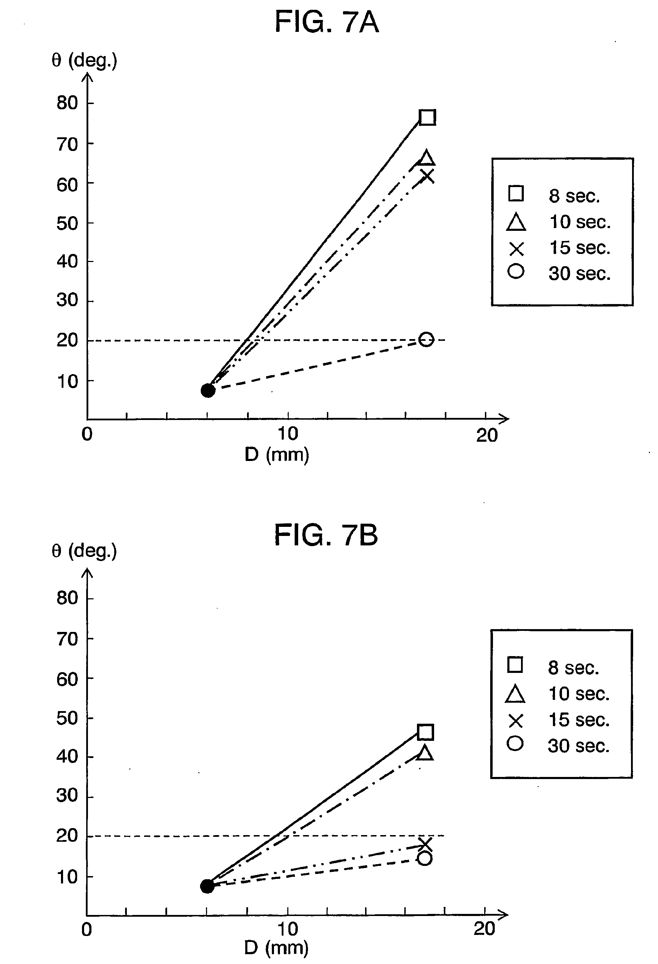

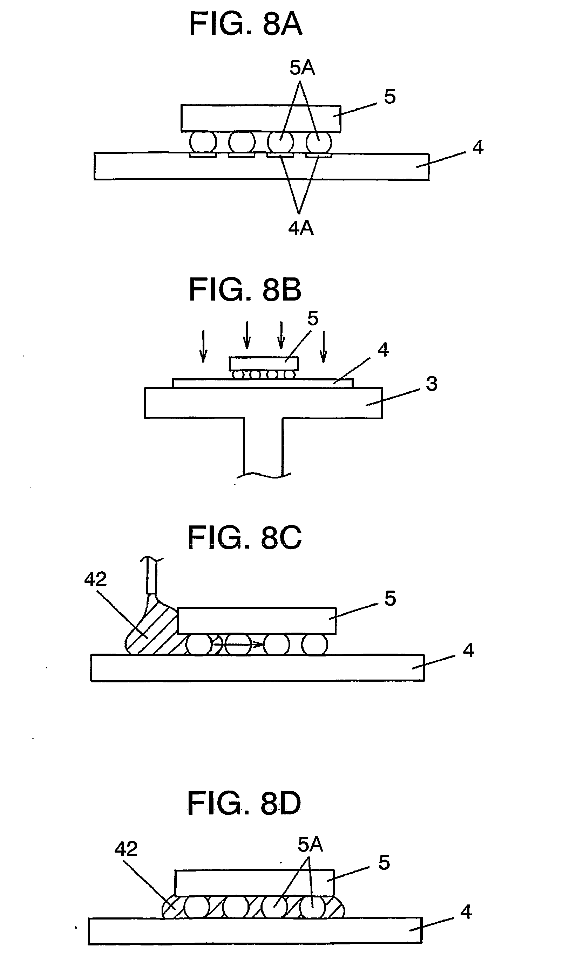

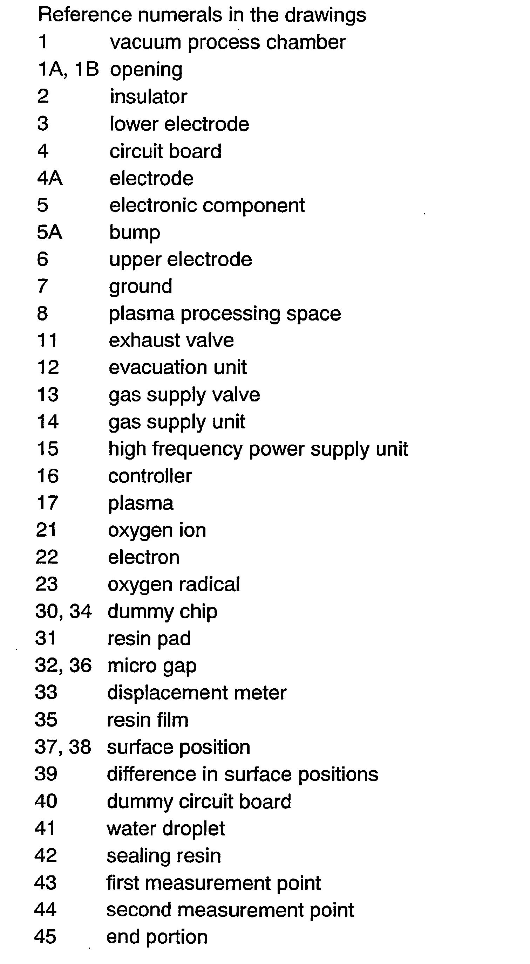

Fig. 1 is a sectional view showing a plasma processing apparatus in accordance with an exemplary embodiment of the present invention; Fig. 2 is a view to illustrate a state of plasma processing space in a plasma processing method in accordance with the exemplary embodiment; Fig. 3 is a view to illustrate a state in which oxygen radicals diffuse in the plasma processing method; Figs. 4A, 4B, 4C, 6A, 6B and 6C are views to illustrate dummy workpieces and experimental method in the plasma processing method in accordance with the exemplary embodiment of the present invention; Figs. 5A, 5B, and 7B are graphs showing the surface modification effect by the plasma processing method in accordance with the exemplary embodiment of the present invention; Fig. 7A is a graph showing the surface modification effect by a conventional plasma processing method; and Figs. 8A to 8D are views to illustrate steps of fabricating an electronic component module in accordance with the exemplary embodiment of the present invention.

Firstly, with reference to Figs. 1 and 2, a plasma processing apparatus is described. Inside vacuum process chamber (hereinafter, referred to as "chamber") 1 forming a hermetically sealed processing chamber, lower electrode (hereinafter, referred to as "electrode") 3 and upper electrode (hereinafter, referred to as "electrode") 6 are disposed vertically with facing each other. Electrodes 3 and 6 are provided at lower and upper parts of chamber 1, respectively. A lower part of electrode 3 penetrates a bottom surface of chamber 1 via insulator 2 and protrudes outwardly, and an upper part of electrode 6 penetrates a top surface of chamber 1 and is connected to ground 7. On an upper surface of electrode 3, circuit board 4 subjected to plasma processing is placed. The plasma processing is performed in space 8 between electrode 3 and electrode 6.

A surface of circuit board 4 is made of ceramic materials, synthetic resin materials, glass, or the like. Electronic component 5 provided with bumps 5A on its lower surface is coupled with circuit board 4 via bumps 5A which are protruding electrodes. Component 5 is a second subject to be processed, which is disposed facing circuit board 4 that is a first subject to be processed with a small gap provided therebetween. The surface of component 5 is covered with synthetic resin materials such as polyimide or inorganic substances such as silicon oxide.

By filling a sealing resin into the micro gap between component 5 and circuit board 4, an electronic component module is produced. Circuit board 4 in Fig. 1 is in a state before it is sent to a step of filling a sealing resin in the gap between component 5 and circuit board 4. The surfaces of component 5 and circuit board 4, which face each other with the micro gap provided therebetween, are modified by the plasma processing, and thereby the wettability of the surfaces with respect to the sealing resin can be improved. Thus, it becomes easy for the sealing resin to enter the micro gap.

The bottom surface of chamber 1 is provided with two openings 1A and 1B. Opening 1A is coupled with evacuation unit 12 via exhaust valve (hereinafter, referred to as "valve") 11. By opening valve 11 and driving evacuation unit 12, the inside of chamber 1 is evacuated.

On the other hand, opening 1B is coupled with gas supply unit 14 via gas supply valve (hereinafter, referred to as "valve") 13. By opening valve 13 and driving gas supply unit 14, the inside of chamber 1 is supplied with gas for plasma discharge. Herein, as the gas for plasma discharge, a mixed gas containing oxygen and helium is used.

To electrode 3, high frequency power supply unit (hereinafter, referred to as "power supply") 15 is connected. By driving power supply 15, high frequency voltage is applied to between electrode 6 and electrode 3. When power supply 15 is driven in a state in which the inside of chamber 1 is evacuated and then plasma-generating gas is supplied, plasma of the above-mentioned mixed gas is generated in space 8.

Controller 16 controls valves 11 and 13, evacuation unit 12, gas supply unit 14 and power supply 15. When evacuation unit 12 and gas supplying unit 14 are driven, controller 16 controls valves 11 and 13. Thus, the pressure of the gas for plasma discharge in space 8 inside chamber 1 can be controlled arbitrarily.

Next, with reference to Fig. 2, the state of space 8 when plasma is generated by the gas for plasma discharge is described. When high frequency voltage is applied so as to generate plasma discharge between electrodes 3 and 6, plasma 17 of oxygen gas is generated, and charged particles such as oxygen ions (O⁺) 21, and electrons 22, etc. and gas particles containing oxygen radicals (O*) 23 are generated in space 8. Oxygen ion 21 and electron 22 are positively charged particle and negatively charged particle, respectively. Furthermore, oxygen radical 23 is electrically neutral particle in which oxygen atom is activated.

In such a state in which plasma is generated, when circuit board 4 to which component 5 is mounted is placed on electrode 3, a surface of resin materials constituting circuit board 4 and component 5 is partially removed. Alternatively, when these materials are a material other than resin, an organic substance attached to the surface is removed. This is performed by physical action, that is, a sputtering effect in which these gas particles crash into the surface of the subjects to be processed, or chemical action of oxygen radical 23 that is an active substance in gas particles.

In the plasma processing directed to circuit board 4, electrically neutral particles such as oxygen radicals 23 enter the micro gap between the upper surface of circuit board 4 and component 5 as shown in Fig. 3. Then, by physical action and chemical action of gas particles, an organic substance is removed and the internal surface of the micro gap, that is, surfaces of circuit board 4 and component 5 is modified.

Component 5 shown in this exemplary embodiment is a multi-pin fine-pitch type flip chip and is mounted to circuit board 4 with a micro gap of 100 µm or less provided therebetween. Accordingly, in a state in which plasma discharge occurs, the entering degree of gas particles such as oxygen radicals 23, which contribute to the surface modification, is low. Furthermore, since gas particles entering the micro gap are prevented from diffusing by a number of bumps 5A, the surface modification effect by plasma processing cannot easily reach the vicinity of the center of the micro gap.

Therefore, in order to secure the surface modification effect by plasma processing, the number of gas particles such as oxygen radicals 23 reaching the surface to be processed is required to increase as many as possible. The number of particles to reach is dependent on the diffusion coefficient of gas particles. The larger the diffusion coefficient is, the more the number of particles to reach is. Therefore, in the plasma processing in which the inside of the micro gap is a subject to be processed, it is desirable to realize a state in which the diffusion coefficient becomes as large as possible.

In plasma processing performed under reduced pressure, gas particles behave as molecular flow, and the diffusion coefficient becomes a larger value as the mass of gas particles is smaller in irrelevant to gas pressure. The relation between the mass of gas particles and the diffusion coefficient hold true even when the gas composition is a single gas or a mixed gas containing plural kinds of gases. That is to say, in a case where a mixed gas is obtained by adding other kinds of gases having a molecular weight smaller than that of a single gas into the single gas, the diffusion coefficient of the thus obtained mixed gas becomes larger than that of the single gas.

In this exemplary embodiment, by using the relation between the mass of gas particles and the diffusion coefficient, the diffusion coefficient is increased so as to increase the number of particles to reach. That is to say, a mixed gas obtained by adding a gas having a molecular weight smaller than that of oxygen gas O₂ (molecular weight: 32) into oxygen gas is used as the gas for plasma discharge. As a gas to be added to oxygen gas, helium (molecular weight: 4) is selected. When helium is added to oxygen gas in this way, the diffusion coefficient of the mixed gas obtained by adding helium to oxygen gas is two times or more than the value of the diffusion coefficient of single oxygen gas.

Then, an experiment for obtaining the optimum mixing ratio of helium when the above-mentioned mixed gas is used as a gas for plasma discharge of plasma processing is described with reference to Figs. 4A to 5B.

Figs. 4A to 4C are views to illustrate dummy workpieces and experimental method used in this experiment. On a lower surface of dummy chip 30, resin pads 31 for quantifying an etching amount by plasma processing are provided. Dummy chip 30 is placed on dummy circuit board 40 with resin pads 31 facing a side of dummy circuit board 40.

Dummy chip 30 is placed facing dummy circuit board 40 with micro gap 32 provided therebetween. Micro gap 32 has gap width G corresponding to a mounting gap between circuit board 4 and component 5 in a real workpiece. Gap width G is, for example, 100 µm. Thus, resin pads 31 are located in gap 32. Then, plasma processing is performed by using the plasma processing apparatus shown in Fig. 1 directed to dummy circuit board 40 on which dummy chip 30 is placed facing thereto.

In plasma processing, gas particles such as oxygen radicals 23 having the surface modification effect shown in Fig. 3 enters gap 32. Thereby, resin pads 31 are etched by the physical action and chemical action of gas particles and organic substance on the surfaces of resin pads 31 are partially removed.

Surface positions 37 and 38 of resin pads 31 before and after this plasma processing are measured by displacement meter 33, and difference 39 between surface positions 37 and 38 is calculated. Thus, indicators each showing an amount of the surface of each resin pad 31 removed by plasma processing, that is, an etching amount, is calculated. Such an experiment is carried out by varying the mixing ratios of helium, and indicators of the etching amount in experiments are calculated. Thereby, it is possible to know that the optimum mixing ratio of helium in terms of increasing the diffusion coefficient. Herein, the mixing ratio of helium means the volume percent of helium in the mixed gas. Note here that the pressure condition of the plasma processing in this experiment is 80 Pa.

Figs. 5A and 5B are graphs showing the results of experiment performed as mentioned above. As shown in Fig. 5A, measured value points showing the calculated indicators of etching amount are considerably distributed by the mixing ratios. However, the mixing ratio of helium is roughly classified into three regions, i. e., regions A, B and C based on the distribution tendency of the measured value points. In region A, in accordance with the increase of the mixing ratio of helium, the etching amount is largely increased. The mixing ratio of helium in region A is 0 vol% or more and less than 2.5 vol%. In region B, the etching amount is large on average, although it distributes depending upon the mixing ratio of helium. The mixing ratio of helium in region B is 2.5 vol% or more and 26 vol% or less. In region C, in accordance with the increase of the mixing ratio of helium, the etching amount is decreased. The mixing ratio of helium in region C is more than 26 vol%.

According to such experimental results, it is preferable that the range of the optimum mixing ratio of helium is set to region B from the viewpoint of increasing the diffusion coefficient. The indicator value of the average etching amount in region B is 140 nm. That is to say, as shown in Fig. 5B, the range of the mixing ratio of helium (2 vol% to 26 vol%) in which the indicator value becomes 140 nm is a range of the appropriate mixing ratio of helium used in a mixture with oxygen gas in plasma processing for the purpose of surface modification of the inner surface of the micro gap.

Next, with reference to Figs. 6A to 7B, the results of experiment for demonstrating the influence of the increase in the diffusion coefficient by mixing helium into a plasma discharge gas on the surface modification effect in the micro gap is described. Herein, the improvement of the surface modification effect in the micro gap, that is, the improvement state of the wettability of the resin film surface after plasma processing is evaluated by measuring a contact angle of water droplet.

Figs. 6A and 6B show dummy workpieces and experimental method used in the experiment. On a lower surface of dummy chip 34, smooth resin film 35 for evaluating the improvement state of the wettability is provided. Dummy chip 34 is placed on dummy circuit board 40 with resin film 35 facing a side of dummy circuit board 40. At this time, similar to the example shown in Fig. 4A, dummy chip 34 is placed facing dummy circuit board 40 with micro gap 36 provided therebetween. Micro gap 36 has gap width G corresponding to a mounting gap between a circuit board and a component in a real workpiece. Gap width G is, for example, 100 µm. Then, plasma processing is performed by using the plasma processing apparatus shown in Fig. 1 directed to dummy circuit board 40 provided with dummy chip 34.

In plasma processing, gas particles such as oxygen radicals 23 having the surface modification effect shown in Fig. 3 enter micro gap 36. Thus, the surface of resin film 35 is etched by physical action and chemical action of gas particles and the surface of resin film 35 is modefied. In the plasma processing directed to the inside of micro gap 36, the closer a point to be processed is located to a deep place of the gap rather than an inlet, that is, the closer the point to be processed is to the inner portion of dummy chip 34 rather than end portion 45, the less surface modification effect reaches.

In this experiment, at two measurement points 43 and 44 provided on dummy chip 34 as shown in Fig. 6B, contact angles of water droplet 41 are measured for determining the wettability of the surface of resin film 34 as shown in Fig. 6C. Based on the measurement results, the improvement state of the surface modification effect can be confirmed. First measurement point 43 is a point that is 6 mm distant from end portion 45 and provided at the position relatively close to end portion 45. Second measurement point 44 is a point that is 17 mm distant from end portion 45 and corresponds to the deep portion in the micro gap in real electronic component 5.

Figs. 7A and 7B show results of experiment performed for confirming the improvement state of such a surface modification effect. Fig. 7A shows the measurement results of contact angles of water droplet 41 at measurement points 43 and 44 in the case where plasma processing is performed by a conventional process. That is to say, as a gas for plasma discharge, only oxygen gas without containing helium is used. The results of experiment performed under conditions where the pressure is 50 Pa and processing time is changed to four certain times from 8 seconds to 30 seconds are shown in one graph.

In plasma processing using the conventional process, at first measurement point 43 that is close to an inlet of the micro gap, contact angles of less than 10° are obtained in any times. These values are less than an acceptable upper limit contact angle as a criterion. As the practical acceptable upper limit contact angle, 20°, which was obtained empirically for securing the sufficient wettability, is employed herein. However, in second measurement point 44 corresponding to a deep portion of the micro gap, the obtained contact angles are largely distributed depending upon the processing times. The measurement result obtained when the processing time is 30 seconds, that is, the longest processing time is barely close to the acceptable upper limit angle 20°.

Fig. 7B shows the measurement results of contact angles of water droplet 41 at measurement points 43 and 44 in the case where plasma processing is carried out by the process according to the exemplary embodiment. That is to say, in this case, the plasma processing is performed under conditions where a mixed gas containing oxygen gas and helium is used and pressure is 80 Pa. In this case, the measurement result at first measurement point 43 that is close to an inlet of the micro gap is not so different from that of the conventional process shown in Fig. 7A. However, the contact angle at second measurement point 44 corresponding to a deep portion of the micro gap is largely decreased at any processing times. That is to say, even in the case where the processing time is 15 seconds, the measurement result that the contact angle is less than 20° is obtained, showing that the surface modification effect is remarkably improved.

According to this experimental result, in order to obtain the acceptable upper limit contact angle of 20° at the deep portion in the micro gap using the conventional process, about 30 seconds are required. On the contrary, a mixed gas containing oxygen gas and helium is used as a gas for plasma discharge, equal or higher surface modification effect can be obtained for 15 seconds of processing time. In other words, the time necessary for plasma processing reduces by half. Therefore, the productivity by a plasma processing step performed as a step prior to filling of resin can be considerably improved.

With reference to Figs. 8A to 8D, a method for fabricating an electronic component module by filling a sealing resin in the micro gap between circuit board 4 and electronic component 5 that is coupled with circuit board 4 via bumps 5A is described. Firstly, as shown in Fig. 8A, component 5 provided with bumps 5A on its lower surface and circuit board 4 are disposed facing each other with a micro gap provided therebetween, so that component 5 and electrode 4A of circuit board 4 are coupled with each other via bumps 5A. That is to say, electrode 4A as a first electrode and bump 5A as a second electrode are coupled with each other with a micro gap provided between component 5 and circuit board 4.

Next, as shown in Fig. 8B, circuit board 4 coupled with component 5 is subjected to plasma processing. That it to say, circuit board 4 is introduced into chamber 1 of the plasma processing apparatus shown in Fig. 1 and placed on electrode 3. Then, in space 8 produced in evacuating chamber 1 where pressure is reduced, plasma processing is performed by using a mixed gas containing oxygen and helium as a gas for plasma discharge. Conditions of the plasma processing are determined based on the above-mentioned results of the experiments using the dummy workpieces. For example, a mixing ratio of helium is 15 vol%, pressure is 80Pa, and processing time is 15 minutes. Thus, the surfaces of component 5 and circuit board 4, which face each other with a micro gap provided therebetween, is modified.

Thereafter, circuit board 4 is taken out from chamber 1, and as shown in Fig. 8C, sealing resin (hereinafter, referred to as "resin") 42 is applied to circuit board 4 and allowed resin 42 to enter and to fill into the surface-modified micro gap by capillary force. Since the wettability of the internal surface of the micro gap is improved by plasma processing for the purpose of surface modification in the previous step, the filling property of resin 42 is improved. Especially, a remarkable improvement is obtained under a condition of the mixing ratio of helium in the range of 2 vol% to 26 vol%. Thereafter, as shown in Fig. 8D, circuit board 4 is heated so as to thermo-harden resin 42, and thereby an electronic component module is completed, in which resin is sealed even in a deep portion of the micro gap between component 5 and circuit board 4.

The experimental result is described when the size of the micro gap is 100 µm. However, the method is effective when the size of the micro gap is 200 µm or less and the number of bumps existing in the micro gap is larger (100 bumps or more).

### INDUSTRIAL APPLICABILITY

In a plasma processing method of the present invention, a large number of gas particles enter a micro gap subjected to plasma processing, and thus surface modification can be carried out efficiently. This method can be used for fabricating an electronic component module that is produced by filling a resin in a micro gap between a circuit board and an electronic component that is coupled with the circuit board via protruding electrodes.

## Claims

1. A method for fabricating an electronic component module, the method comprising:
coupling a first electrode of a circuit board (4) to a second electrode (5A) of an electronic component (5) with a micro gap provided between the circuit board (4) and the electronic component (5);
disposing the circuit board (4) coupled with the electronic component (5) within a process chamber (1);
reducing a pressure inside the process chamber (1) and introducing a mixed gas;
generating plasma inside the pressure-reduced process chamber (1), thereby processing surfaces of the circuit board (4) and the electronic component (5) facing each other in the micro gap; and
filling resin in the micro-gap and hardening the resin after the plasma processing step,
**characterised in that** said mixed gas contains oxygen and helium.

2. The method for fabricating an electronic component module according to claim 1, wherein a ratio by volume of helium in the mixed gas is at least 2% and at most 26%.

## Patentansprüche

1. Verfahren zur Herstellung eines elektronischen Komponentenmoduls mit den Schritten:
Verbinden einer ersten Elektrode einer Leiterplatte (4) mit einer zweiten Elektrode (5A) einer elektronischen Komponente (5) mit einem Mikrospalt, der zwischen der Leiterplatte (4) und der elektronischen Komponente (5) vorgesehen ist ;
Anordnen der mit der elektronischen Komponente (5) verbundenen Leiterplatte (4) in einer Prozesskammer (1);
Mindern eines Drucks in der Prozesskammer (1) und Einleiten eines Gasgemisches;
Erzeugen eines Plasmas in der druckgeminderten Prozesskammer (1), wodurch Oberflächen der Leiterplatte (4) und der elektronischen Komponente (5), die in dem Mikrospalt einander gegenüberliegen, behandelt werden; und
Verfüllen des Mikrospalts mit Harz und Aushärten des Harzes nach dem Plasmabehandlungsschritt,
**dadurch gekennzeichnet, dass** das Gasgemisch Sauerstoff und Helium enthält.

2. Verfahren zur Herstellung eines elektronischen Komponentenmoduls nach Anspruch 1, **dadurch gekennzeichnet, dass** ein Volumenanteil von Helium in dem Gasgemisch mindestens 2 % und höchstens 26 % beträgt.

## Revendications

1. Procédé pour fabriquer un module de composant électronique, le procédé comprenant:
coupler une première électrode d'une carte de circuit (4) à une deuxième électrode (5A) d'un composant électronique (5) avec un micro-jeu pourvu entre la carte de circuit (4) et le composant électronique (5);
disposer la carte de circuit (4) couplée au composant électronique (5) dans une chambre de traitement (1);
réduire une pression à l'intérieur de la chambre de traitement (1) et introduire un gaz mélangé;
générer du plasma à l'intérieur de la chambre de traitement à pression réduite (1), traitant ainsi des surfaces de la carte de circuit (4) et du composant électronique (5) se faisant face dans le micro-jeu; et
remplir le micro-jeu avec de la résine et durcir la résine après l'étape de traitement au plasma,
**caractérisé en ce que** ledit gaz mélangé contient de l'oxygène et de l'hélium.

2. Procédé pour fabriquer un module de composant électronique selon la revendication 1, où un rapport en volume d'hélium dans le gaz mélangé est de 2% au moins et de 26% au plus.
